(19) Europäisches Patentamt

European Patent Office

Office européen des brevets

(11) EP 1 326 391 A1

## (12) EUROPEAN PATENT APPLICATION

(43) Date of publication:
09.07.2003 Bulletin 2003/28

(51) Int Cl.7: H04L 25/03, H04L 25/06

(21) Application number: 02090346.4

(22) Date of filing: 27.09.2002

| | |
|---|---|
| (84) Designated Contracting States: **AT BE BG CH CY CZ DE DK EE ES FI FR GB GR IE IT LI LU MC NL PT SE SK TR** Designated Extension States: **AL LT LV MK RO SI** | (72) Inventor: **Bodenschatz, John S.** **Irvine, California 92618 (US)** |
| (30) Priority: **02.10.2001 US 970212** | (74) Representative: **Jehle, Volker Armin, Dipl.-Ing. et al Patentanwälte Bosch, Graf von Stosch, Jehle,** |
| (71) Applicant: **Broadcom Corporation Irvine, CA 92619-3616 (US)** | **Flüggenstrasse 13 80639 München (DE)** |

(54) **Adaptive thresholding for adaptive equalization**

(57) Adaptive thresholding techniques provide adaptive equalization by making the calculation of the error feedback signal adaptive. Typically, the error feedback signal is based on a comparison of the filter output with a set of thresholds. The largest tap weight is defined as unity and the other tap weights are confined to values less than unity. The invention provides several advantages. A multiply is removed, the dynamic range of the system is increased and the overall performance of the system is improved. Moreover, the teachings of the invention may be applied to virtually any method of performing adaptive equalization without a known desired signal.

Fig. 4

**Description**

FIELD OF THE INVENTION

The invention relates generally to data communications and, more particularly, to systems and methods for adaptive equalization.

BACKGROUND OF THE INVENTION

A typical application of signal equalization in a data communication system involves filtering a received signal to extract the signal that was originally transmitted from the received signal. For example, when a signal is transmitted through a noisy medium the received signal will consist of a combination of the originally transmitted signal and noise signals induced by the medium. Thus, equalization techniques may be employed at the receiver to attempt to remove the noise signals from the received signal.

Typically, adaptive equalization involves providing equalization using an adaptable filter. For example, a transversal adaptive filter consists of several delay lines connected in series. The output of each delay line (commonly referred to as a tap) is multiplied by an adjustable weighting factor. The output of the filter consists of the sum of these products. By adjusting the value of the weighting factors, the characteristics of the filter may be changed thereby providing adaptive equalization.

In general, a filter is defined by three characteristics: 1) the structure (transversal, lattice, etc.); 2) the optimization method (stochastic gradient, stochastic Newton, etc.); and 3) the implementation (implementations differ in their work factors and memory requirements).

Least-Mean-Square (LMS) and Recursive Least Squares (RLS) are two common adaptive filters. Both use a tapped delay line; the difference is that LMS is a stochastic gradient method, whereas RLS is a stochastic Newton method.

Adaptive equalization/filtering has many uses. The pioneering paper "Adaptive Noise Canceling: Principles and Applications" by Widrow, B. et al, Proceedings of the IEEE, vol. 63, no. 12, pp. 1692-1716, December, 1975, discusses interference cancellation for electrocardiography, speech, and antennas, as well as, periodic signal removal. The book Adaptive Filter Theory, Haykin, S., Prentice Hall, 1975 (3rd edition), groups adaptive filtering applications into four classes: system identification, inverse modeling, prediction, and interference cancellation. A great deal of research is still being performed in this area, as it forms the cornerstone of many equalization techniques.

Although conventional adaptive equalization techniques are effective, many of these techniques are computationally complex. For example, the equalization algorithms may involve a large number of multiply operations or may use a large number of bits to represent the variables used in the algorithms. Complexities such as these may result in relatively long executions times for the algorithms. In addition, the multipliers that perform the multiply operations utilize relatively large areas of the integrated circuit. These factors affect the cost, precision and performance of the filter.

SUMMARY OF THE INVENTION

The invention is directed to methods and associated systems that use adaptive thresholds to accomplish adaptive equalization. In general, threshold values are defined according to the type of signal being processed by the filter. The output of the filter is then compared to the threshold values. To accomplish adaptation, the tap weights of the filter are adjusted based on this comparison.

The adaptive thresholding technique includes replacing the largest tap with unity and making the calculation of an error signal $e_i$ adaptive. This largest tap is referred to as the "unity tap." During operation, the taps other than the unity tap are constrained to have a magnitude less than unity.

Adaptive thresholding can be applied to any channel where this constraint does not interfere with performance. Adaptive thresholding can be applied to a wide range of channels, such as phone lines, twisted pair cables, reading magnetic recordings, etc. Typically, the inverse channel will have its highest magnitude tap in the center. However, certain inverse channels may be more accurately computed by having the largest tap off center.

In one embodiment involving decision-directed equalization, a desired response $d_i$ is calculated by comparing the filter output to a set of thresholds. The desired response is used to calculate the error signal which, in turn, is used to generate new weights for the taps. The result of a comparison of the filter output to the thresholds is then used to update the thresholds.

Adaptive thresholding is a useful technique for applications such as channel identification. The teachings of the invention may be applied to virtually any method of performing adaptive equalization without a known desired signal. For example, adaptive thresholding may be combined with filter adaptation algorithms such as LMS, RLS, etc., as long as the memory of the algorithm is finite.

There are several advantages associated with performing equalization in accordance with the invention. For example, a multiply in the calculation of the error signal may be removed. In addition, the dynamic range of the system may be increased. Moreover, the overall performance of the system may be improved.

BRIEF DESCRIPTION OF THE DRAWINGS

These and other features, aspects and advantages of the present invention will be more fully understood when considered with respect to the following detailed description, appended claims and accompanying drawings, wherein:

Figure 1 is a block diagram of one embodiment of an adaptive equalizer constructed in accordance with the invention;
Figure 2 is a block diagram of one embodiment of a tapped delay line with tap weighting;
Figure 3 is a block diagram of one embodiment of a transversal filter with tap weight updating;
Figure 4 is a block diagram of one embodiment of an adaptive equalizer constructed in accordance with the invention;
Figure 5 is a flowchart representative of one embodiment of adaptive equalization operations that may be performed in accordance with the invention;
Figure 6 is a block diagram of one embodiment of a threshold comparator for an adaptive equalizer constructed in accordance with the invention;
Figure 7 is a block diagram of one embodiment of a data communications system incorporating adaptive equalization in accordance with the invention; and
Figure 8 is a block diagram of one embodiment of a media storage system incorporating adaptive equalization in accordance with the invention.

DETAILED DESCRIPTION OF THE INVENTION

The invention is described below, with reference to detailed illustrative embodiments. It will be apparent that the invention can be embodied in a wide variety of forms, some of which may be quite different from those of the disclosed embodiments. Consequently, the specific structural and functional details disclosed herein are merely representative and do not limit the scope of the invention.

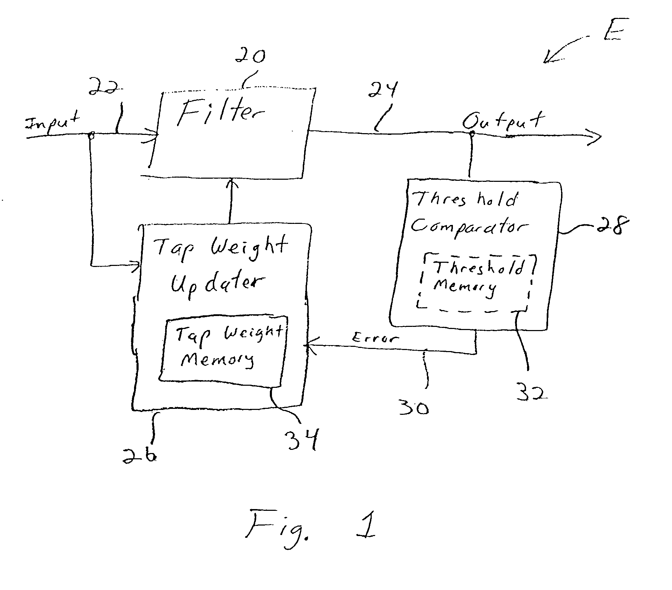

Figure 1 is a simplified block diagram of one embodiment of an adaptive equalizer E incorporating adaptive thresholding according to the invention. A filter 20 filters an input signal 22 to produce an output signal 24. The filter 20 includes tap weights (not shown) that are updated by a tap weight updater 26. In accordance with one embodiment of the invention a threshold comparator 28 compares the output signal 24 with one or more thresholds stored in a threshold memory 32 to provide an error signal 30 to the tap weight updater 26. Thus, the tap weight updater 26 adapts the tap weights based on the error signal 30. In one embodiment of the invention the tap weights are stored in a tap weight memory 36.

The teachings of the invention may be better understood by consideration of particular embodiments of the invention. Preliminary to such consideration, the principles of conventional adaptive filters will be discussed.

There is an inherent relationship between automatic gain control and tapped filters. If there is only one tap in the filter, the signal is merely multiplied by a factor. Since the factor is set automatically, it is often termed Automatic Gain Control (AGC). If there is more than one tap, the scale of all of the taps is usually free to vary. Thus, a filter can essentially have a built-in AGC. Other designs place an additional AGC in front of the filter to provide course adjustment of the gain. Hence, an AGC in the system can normally be viewed as part of the filter.

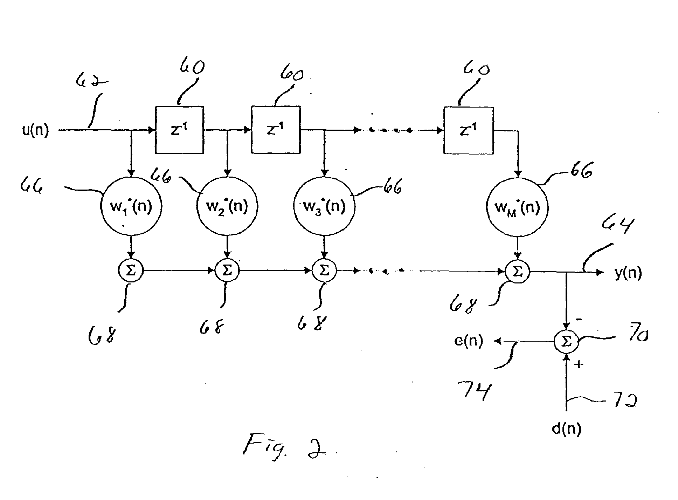

A transversal filter (or tapped delay line) is the most common filter structure. A tapped delay line comprising a series of delay elements 60 is illustrated in Figure 2. The input to the filter is the signal u(n) 62. The output of each tap is weighted by a tap weight element 66 defined by a tap vector $w_1$, $w_2$, etc. A series of adders 68 sum these products to produce the filter output y(n) 64.

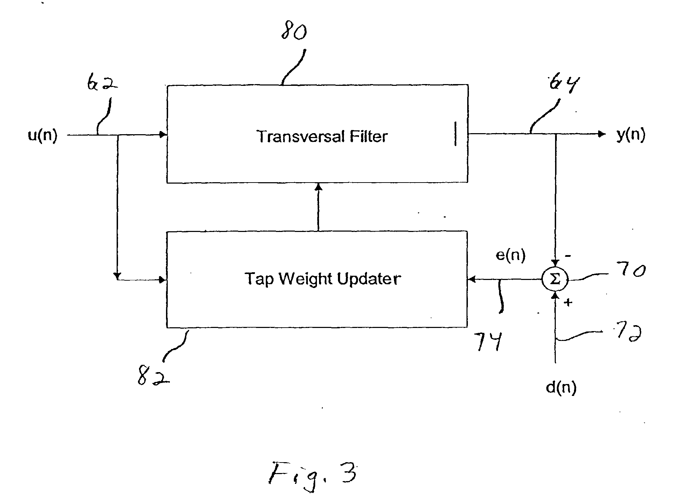

In an adaptive transversal filter, each tap vector w is adjusted according to some adaptation criterion or cost function. Figure 3 illustrates a tap weight adapter 82 that updates the tap weights for a transversal filter 80 according to an error signal e(n) 74.

Using the notation and perspective of Haykin, the equation for this error at time *i* is

$$e_i = d_i - w_i^H u_i \hspace{4cm} \text{EQUATION 1}$$

where

$d_i$ is the desired response which is provided to the filter.
$u_i$ is the input vector.
$w_i$ is the tap vector.
$w^T_i u_i$ is the filter output.

The superscript $H$ indicates a Hermitian transpose, which is equivalent to a standard transpose for real data.
The filter output is

$$y_i = w_i^H u_i \qquad\qquad \text{EQUATION 2}$$

The single channel filtering input vector is defined by

$$u_i = [u_i, u_{i-1}, ..., u_{i-L-1}]^T \qquad\qquad \text{EQUATION 3}$$

where

$u_i$ is the discrete-time signal, and
$L$ is the filter length.

In other words, this $u_i$ is a tapped-delay line and $w^T$ contains the weighting values of each tap.
In the Least Squares (LS) adaption criterion, the goal is to minimize the power of the error signal, as given by

$$E\left\{\left|e_i\right|^2\right\}, \qquad\qquad \text{EQUATION 4}$$

which corresponds to minimizing the sample variance given by

$$\hat{\sigma} = \frac{1}{K}\sum_{i=1}^{K}\left|e_i\right|^2. \qquad\qquad \text{EQUATION 5}$$

In the Least-Mean-Square (LMS) technique the LS criterion is implemented by adjusting the tap vector $w_i$ by the multiple of the product of the error $e_i$ and the input vector $u_i$.

$$e_i = d_i - w_i^T u_i \qquad\qquad \text{EQUATION 6}$$

$$w_{i+1} = w_i + \mu u_i e_i \qquad\qquad \text{EQUATION 7}$$

This is a stochastic gradient algorithm, because each step may not proceed down the gradient. In other words, convergence only will occur in the average, assuming certain stability conditions are satisfied.
The Zero-Forcing Least-Mean-Square (ZFLMS), also known as the Sign-Sign (SS) algorithm is like LMS, but the multiply is performed only upon the sign bits,

$$w_{i+1} = w_i + \mu\, sign(u_i) sign(e_i). \qquad\qquad \text{EQUATION 8}$$

This is more suitable for real-time applications, because it avoids the multiplications. Under certain conditions, ZFLMS can be proven to converge to the same point as LMS. See Bodenschatz, J. and Nikias, C.L., "Symmetric alpha-stable filter theory," IEEE Transactions on Signal Processing, vol. 45, no. 9, pp. 2301-06, 1997.

There are many other methods to adapt the filter taps, such as algorithms based upon recursive least squares.

The most common method of channel equalization uses an adaptive equalizer to undo the effects of the channel. While this generally does not remove all of the channel effects, it is still a very powerful technique. If the transmitted signal is known, a value of $d_i$ for Equation 6 will be known. An example of this is the use in voice-grade modems of a known training sequence for initialization. If the desired signal, $d_i$, is not known, but the signal being equalized is a bauded signal with a finite constellation of transmitted values, "decision-directed equalization" or "blind equalization" may be used.

In decision-directed equalization, the desired signal, $d_i$, is chosen as the closest point on the transmitted constellation. This gives us an error, $e_i$, from Equation 6 to use in the tap update equations, such as Equations 7 or 8.

There are many types of blind equalization techniques. These techniques rely on statistics to calculate a value of $e_i$ for use in the tap update equations, such as Equations 7 or 8.

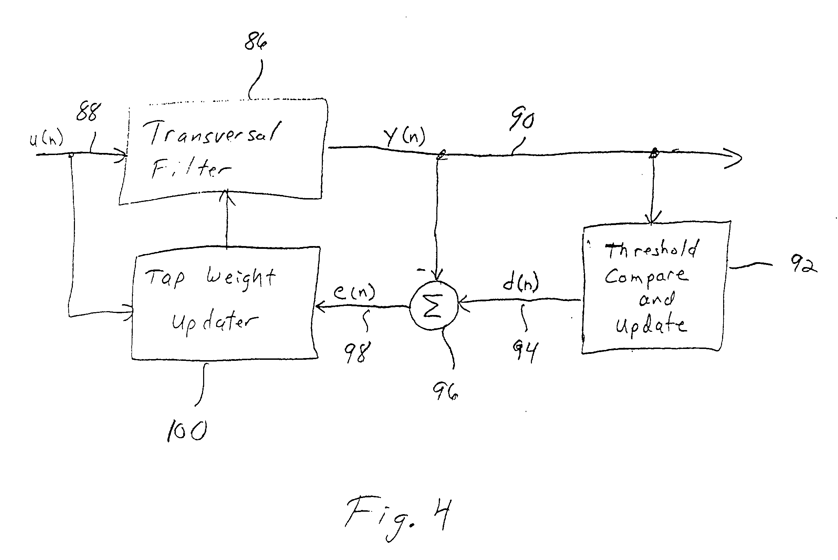

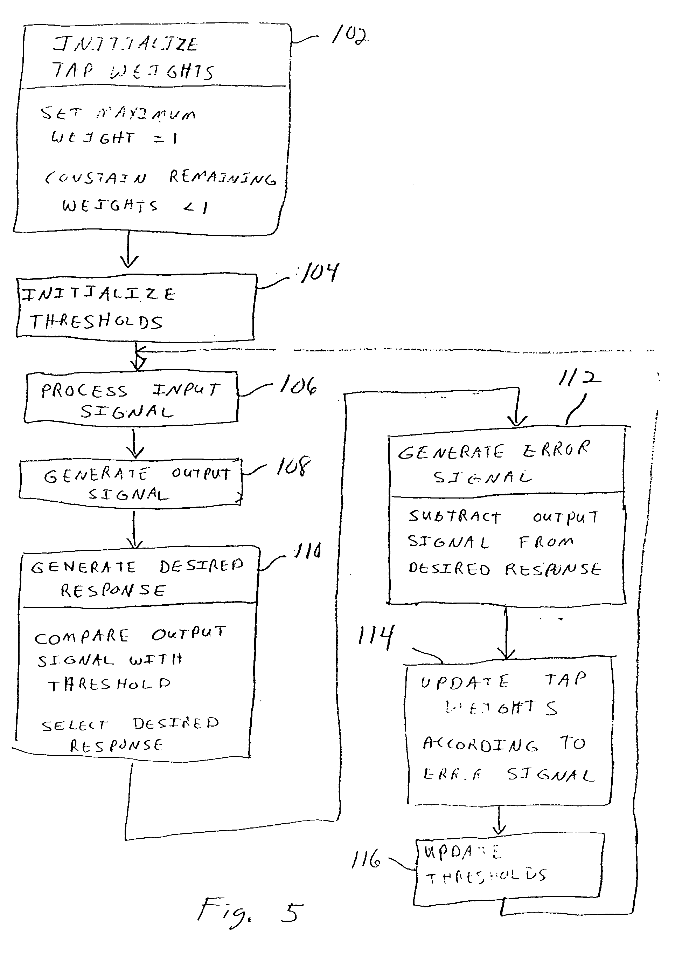

Figure 4 illustrates one embodiment of a decision directed equalizer in accordance with the invention. The operation of this embodiment will be discussed in conjunction with the flowchart of Figure 5.

Briefly, as described in Figure 4 the equalizer includes a transversal filter 86 that operates in conjunction with a threshold compare and update circuit 92 and a tap weight updater 100 to process an input signal u(n) 88 to produce an output signal y(n) 90. Referring to Figure 5, initially, as described at block 102, the weight of each tap is set. As discussed above, the largest tap is set to unity and the taps other than the unity tap will be constrained to have a magnitude less than unity. While the other taps typically are initialized to zero; they could be set to some other value to facilitate convergence.

As described at block 104, the thresholds are set to an initial value. For constellations other than BPSK, the value of the threshold should be initialized to a value that is reasonable close to the scaled value expected for the various points in the constellation. Typically this is a relative simple operation, although it may require an additional initialization algorithm. In one embodiment the initialization algorithm is based on the incoming signal strength.

As the transversal filter 86 processes the input signal u(n) 88 (block 106) it generates an output y(n) 90 that is routed to the threshold compare and update circuit 92 (block 108). As represented by block 110, the threshold compare and update circuit 92 compares y(n) 90 with one or more thresholds to select a desired response d(n) 94. This operation is discussed in more detail below in conjunction with specific decision directed applications. An adder 96 subtracts y(n) 90 from d(n) 94 to produce an error signal e(n) 98 (block 112). Next, the tap weight updater 100 updates the tap weights based, in part, on e(n) 98 and u(n) 88 (block 114). Again, the tap weights are constrained to unity and less than unity as discussed above. Then, at block 116, the threshold compare and update circuit 92 updates the thresholds based on comparison of y(n) 90 with the thresholds. The process then repeats to process each sample of the input signal, continually updating the tap weights and the thresholds to adapt to, for example, the transmission channel.

The adaptation to calculate the threshold may be better understood by illustrating the operation with a specific example. The following example involves a three level signal such as MLT3. The transmitted signal can be viewed as being { -1, 0, 1 }. After equalization, all outputs should fall around scaled version of those three levels, { -2T, 0, 2T }. For decision-directed equalization, the signal may be deemed high if it is above $T$, and deemed low if it is below -$T$, or more formally:

$$d_i = \begin{cases} 2T & \text{if } y_i \geq T_i \\ 0 & \text{if } -T_i \leq y_i < T_i \\ -2T & \text{if } y_i < -T_i \end{cases} \qquad\qquad \text{EQUATION 9}$$

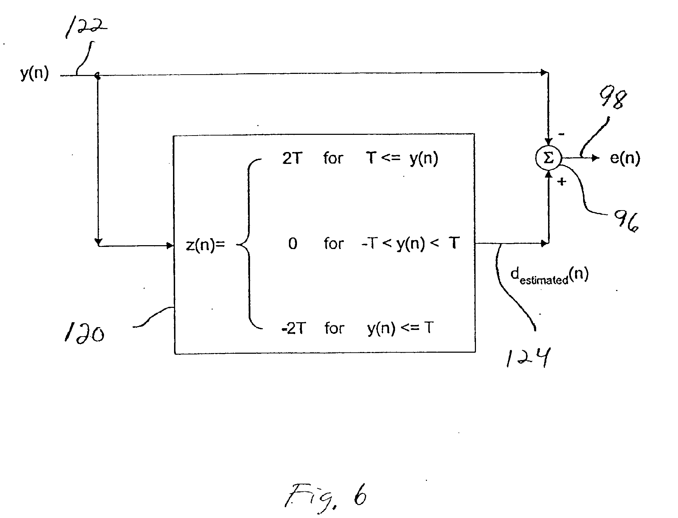

Such a comparison operation is used in the threshold comparator 120 of Figure 6. As described in Figure 6, the threshold comparator 120 compares the input y(n) 122 with the threshold to generate a desired (e.g., estimated) signal d(n) 124.

Statistically, the high signals should be symmetrically clustered around *2T,* and the low signals should be clustered around -*2T.* Therefore, the threshold compare and update procedure can use the following algorithm to update

the threshold:

$$\Delta T_i = \begin{cases} +\mu & if\ (d_i \neq 0)\ and\ |y_i| \geq 2T_i \\ -\mu & if\ (d_i \neq 0)\ and\ |y_i| < 2T_i \\ 0 & if\ (d_i = 0) \end{cases}$$

EQUATION 10

$$T_{i+1} = T_i + \Delta T_i,$$

EQUATION 11

where $\mu$ is a small constant.

Adaptation can also be performed by using a scaled version of the difference:

$$\Delta T_i = \begin{cases} +\mu(|y_i| - 2T_i) & if\ d_i \neq 0 \\ 0 & if\ d_i = 0 \end{cases}$$

EQUATION 12

This is potentially faster, but values of $|y|$ just above $T$, which are likely to be in error, will have a greater impact on $T$ than values near $T$. Thus, the method in Equation 10 typically is more robust.

Adaptive thresholding also is also applicable to Binary Phase-Shift Keying signals. In this case, the decision threshold is constant at zero. However, a value of $d_i$ is needed for Equation 6. This value can be set according to the following equation:

$$d_i = \begin{cases} 2T_i & if\ y_i \geq 0 \\ -2T_i & if\ y_i < 0 \end{cases}$$

EQUATION 13

Then $T_i$ may be adapted using Equation 11 and:

$$\Delta T_i = \begin{cases} +\mu & |y_i| \geq 2T_i \\ -\mu & |y_i| < 2T_i \end{cases}$$

EQUATION 14

In this example, a factor of 2 was used to multiply $T$ in Equation 14 to remain consistent with Equation 9, but this is not necessary here, since this is the only use of $T$, except for its update.

In another embodiment, adaptive thresholding may be used in conjunction with modems that use constellations that may have as many as 256 (or more) points. Here, the decision thresholds and ideal decision values are calculated as multiples of $T$. However, depending upon the specific implementation, these multiplications may be more burdensome than the multiply in the tapped delay line that is being replaced. Thus, adaptive thresholding may, or may not, be advantageous for all implementations.

In another embodiment, adaptive thresholding may be used in conjunction with a decision-feedback equalizer (DFE) that is combined with the transversal filter. The output of the DFE is added to the output $y_i$ of the transversal filter before $e_i$ is calculated. The resulting $e_i$ is used to update both filters. To use adaptive filtering with a DFE, the DFE is added as it would be with a conventional transversal filter. All of the taps of the DFE may remain adaptive.

In another embodiment, adaptive thresholding may be used with algorithms that use a known training sequence. In this case, instead of using the decisions calculations, such as Equations 9 or 14, $d_i$ may be calculated by multiplying by the appropriate factor of $T$.

Blind equalization cost functions contain constants that are calculated from the statistics of the data, such as $E\{|y|^2\}$. To extend the adaptive threshold method to embodiments that use blind equalization, the constants can be re-estimated to track the output. However, a potentially more effective approach involves the use of step-wise adjustments, so that the constants have the correct ratio of output points above and below them. For example, using a Sato algorithm, the error signal, $e_i$, is the vector from $y_i$ to a circle of the appropriate radius. Using the adaptive thresholding algorithm, the radius is adaptively updated, instead of changing the largest tap of the equalizer. As with BPSK, this adaptive quantity is not used as a decision threshold per se, but the manner in which $e_i$ is calculated is adapted.

In general, adaptive thresholding may be combined with any adaptation algorithm that does not have infinite memory. The unity tap is unchanged in the adaptation, and the other taps are adjusted to minimize $e_i$ of Equation 1. Any stochastic gradient algorithm is suitable. Stochastic Newton algorithms can be used, but the memory must be finite. For example, this can be accomplished in RLS by having the $\lambda < 1$, or by using a window of finite length. In effect, the finite memory allows the filter to "forget" the errors $e_i$ that were calculated before the threshold algorithm converged.

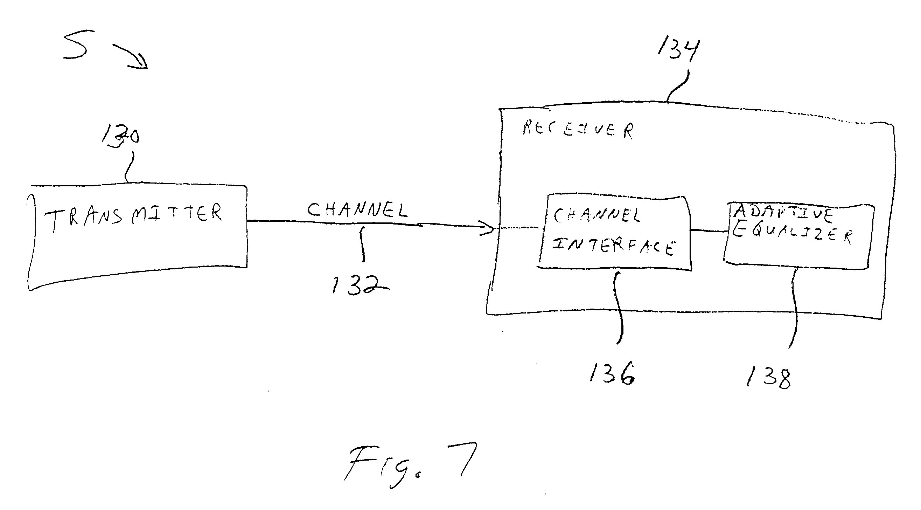

Thus the teaching of the invention can effectively be applied to wide classes of channel equalization including, for example, T100/T1000, QAM, DVI, and magnetic media. Figure 7 illustrates a generalized depiction of a data communication system S consisting of a transmitter 130 that sends a signal over a channel 132 to a receiver 134. Typically the receiver includes a channel interface 136 that is adapted to receive signals from a particular channel (e.g., T100/T1000). The received signals are then processed by an adaptive equalizer 138 in accordance with the teachings herein.

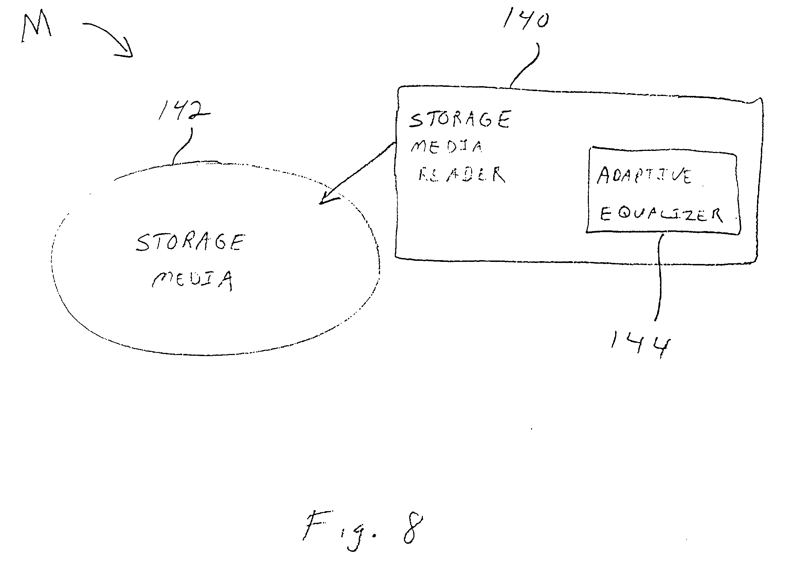

Figure 8 illustrates a generalized depiction of a storage media system M where a storage media reader 140 reads a storage media 142. The storage media reader 140 generates signals that are processed by an adaptive equalizer 144 which, for example, equalizes the signal to remove undesirable signal artifacts introduced by the media 142. For example, the storage media 142 may be a magnetic media or a compact disk media. As discussed above the adaptive equalizer of Figures 7 and 8 may incorporate a variety of adaptive equalization techniques in implementing the teachings of the invention.

Adaptive thresholding provides a number of advantages over some conventional equalization techniques. A multiply may be removed; the dynamic range per number of bits in the system may be increased; and the structure may allow the ratio of the largest/unity tap to the threshold to be computed with greater accuracy, thereby increasing performance.

Replacing the multiply with the thresholding mechanism saves computation, especially since the multiply being replaced typically would need the highest precision of any multiply in the equalizer. In hardware implementations, this is very important for saving silicon area and minimizing path delays, thereby permitting the integrated circuit to be clocked at a higher rate. In real-time DSP software, it reduces computations and increases speed. For non-real time software on a general-purpose computer, it will increase execution speed.

The unity tap constrains the range signal going through the equalizer, reducing the number of bits needed to accurately represent the computed values. The number of bits also is reduced in the DFE, if it is present. In hardware implementations, this reduces gate count; in software, it may permit faster execution. In both cases, it facilitates system design and testing.

In conventional filters, the value of the largest tap may be adjusted relative to a fixed value. Since the largest tap is an input to a multiply, there is a severe practical limit to how many bits can be used to represent it. In the techniques described herein, the largest tap may be held at unity and the value of the threshold adjusted. As the threshold is an input to a compare, it can more practically be represented by many more bits. With precision, the ratio of the largest tap to the threshold has the same theoretical final value. However, the difference in bits allows the ratio to be more accurate with adaptive thresholding. This greater accuracy will result in improved accuracy of filter shape and the filter output.

Typically, a system constructed according to invention will be implemented in an integrated circuit and/or as software code that is executed by a processing device. For example, an equalizer incorporating these techniques may be hardcoded into a data communications transceiver on an integrated circuit and/or a circuit board. In addition, these techniques may be implemented in software that is loaded, for example, into a digital signal processor, a conventional central processing unit or a custom integrated circuit.

In summary, the invention described herein teaches improved techniques for providing adaptive equalization. While certain exemplary embodiments have been described in detail and shown in the accompanying drawings, it is to be understood that such embodiments are merely illustrative of and not restrictive of the broad invention. It will thus be recognized that various modifications may be made to the illustrated and other embodiments of the invention described above, without departing from the broad inventive scope thereof. In view of the above it will be understood that the invention is not limited to the particular embodiments or arrangements disclosed, but is rather intended to cover any changes, adaptations or modifications which are within the scope and spirit of the invention as defined by the appended claims.

**Claims**

1. A method of providing adaptive equalization using an adaptive filter, comprising the steps of:

   storing a plurality of threshold values;
   generating an error signal according to a comparison of an output of the adaptive filter with at least one of the threshold values; and
   updating tap weights of the adaptive filter according to the error signal.

2. The method of claim 1 wherein the step of generating an error signal comprises the steps of:

   generating a desired response signal according to a comparison of an output of the adaptive filter with at least one of the threshold values;
   generating the error signal according to an arithmetic combination of the desired response signal and an output of the adaptive filter.

3. The method of claim 1 wherein the step of updating tap weights comprises setting one of the tap weights to a value of one and constraining each of the remainder of the tap weights to a value of less than one.

4. The method of claim 1 further comprising the step of updating at least one of the threshold values.

5. The method of claim 4 wherein the step of updating at least one of the threshold values comprises modifying at least one of the threshold values by a scaled product of a difference between an output of the adaptive filter and at least one of the threshold values.

6. An adaptive equalizer comprising:

   at least one data memory for storing a plurality of threshold values and a plurality of tap weights;
   at least one adaptive filter, connected to receive the tap weights from the at least one data memory, for generating an output signal;
   at least one threshold comparator, connected to receive an output signal from the at least one adaptive filter and threshold values from the at least one data memory, for generating an error signal according to a comparison of at least one of the threshold values from the at least one data memory with an output signal from the at least one adaptive filter; and
   at least one tap weight updater, connected to receive the error signal from the at least one threshold comparator, for updating at least one of the tap weights stored in the at least one data memory according to the error signal.

7. The adaptive equalizer of claim 6 wherein the at least one threshold comparator generates a desired response signal according to a comparison of an output signal from the at least one adaptive filter with at least one of the threshold values from the at least one data memory, and generates the error signal according to an arithmetic combination of the desired response signal and an output signal from the at least one adaptive filter.

8. The adaptive equalizer of claim 6 wherein the at least one tap weight updater updates the tap weights in the at least one data memory by setting one of the tap weights to a value of one and constraining each of the remainder of the tap weights to a value of less than one.

9. The adaptive equalizer of claim 6 wherein the at least one threshold comparator updates at least one of the threshold values in the at least one data memory.

10. The adaptive equalizer of claim 6 wherein the at least one threshold comparator updates at least one of the threshold values stored in the at least one data memory by modifying at least one of the threshold values by a scaled product of a difference between an output signal from the at least one adaptive filter and at least one of the threshold values.

Fig. 1

Fig. 2

80

62

u(n)

**Transversal Filter**

64

y(n)

**Tap Weight Updater**

82

e(n)

74

-

Σ

70

+

72

d(n)

*Fig. 3*

Fig. 4

EP 1 326 391 A1

INITIALIZE
TAP WEIGHTS — 102

SET MAXIMUM
WEIGHT = 1

CONSTAIN REMAINING
WEIGHTS < 1

INITIALIZE
THRESHOLDS — 104

PROCESS INPUT
SIGNAL — 106

GENERATE OUTPUT
SIGNAL — 108

GENERATE DESIRED
RESPONSE — 110

COMPARE OUTPUT
SIGNAL WITH
THRESHOLD

SELECT DESIRED
RESPONSE

GENERATE ERROR
SIGNAL — 112

SUBTRACT OUTPUT
SIGNAL FROM
DESIRED RESPONSE

114

UPDATE TAP
WEIGHTS

ACCORDING TO
ERROR SIGNAL

116 — UPDATE
THRESHOLDS

Fig. 5

14

122

y(n)

98

$$z(n) = \begin{cases} 2T & \text{for} \quad T <= y(n) \\ 0 & \text{for} \quad -T < y(n) < T \\ -2T & \text{for} \quad y(n) <= T \end{cases}$$

120

- Σ → e(n)

+

96

$d_{estimated}(n)$

124

Fig. 6

EP 1 326 391 A1

S

130

TRANSMITTER

CHANNEL

132

134

RECEIVER

CHANNEL INTERFACE

ADAPTIVE EQUALIZER

136

138

Fig. 7

Fig. 8

EP 1 326 391 A1

**European Patent Office**

# EUROPEAN SEARCH REPORT

Application Number

EP 02 09 0346

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | US 5 151 924 A (MITA SEIICHI ET AL) 29 September 1992 (1992-09-29) * column 1, line 21 - column 2, line 36; figure 2 * * column 3, line 16 - column 4, line 21; figures 1,3A,3B * ----- | 1-10 | H04L25/03 H04L25/06 |

TECHNICAL FIELDS SEARCHED (Int.Cl.7)

H04L

The present search report has been drawn up for all claims

| Place of search | Date of completion of the search | Examiner |
|---|---|---|
| BERLIN | 25 April 2003 | Martínez Martínez, V |

EPO FORM 1503 03.82 (P04C01)

**ANNEX TO THE EUROPEAN SEARCH REPORT
ON EUROPEAN PATENT APPLICATION NO.**

EP 02 09 0346

This annex lists the patent family members relating to the patent documents cited in the above-mentioned European search report.
The members are as contained in the European Patent Office EDP file on
The European Patent Office is in no way liable for these particulars which are merely given for the purpose of information.

25-04-2003

| Patent document cited in search report | Publication date | Patent family member(s) | Publication date |
|---|---|---|---|
| US 5151924 A | 29-09-1992 | JP 2170613 A | 02-07-1990 |

EPO FORM P0459

For more details about this annex : see Official Journal of the European Patent Office, No. 12/82